# EUROPEAN PATENT APPLICATION

(11) **EP 2 450 963 A2**
(43) Date of publication of application: **09.05.2012**
(21) Application number: 10794346.6
(22) Date of filing: 30.06.2010
(51) Int. Cl.: H01L 31/042

(54) **SOLAR CELL AND METHOD FOR PRODUCING SAME**

(30) Priority: 30.06.2009 KR 20090059504
(71) Applicant: LG Innotek Co., Ltd., Seoul 100-714 (KR)
(72) Inventor: SUNG, Myoung Seok, Seoul 100-714 (KR)
(74) Representative: Novagraaf Technologies
(86) International application number: PCT/KR2010/004225
(87) International publication number: WO 2011/002211

(57) **Abstract**

The solar battery according to embodiments includes a substrate having an effective area and an edge area disposed outside the effective area; and a solar battery cell formed on the effective area of the substrate and comprising a first electrode, a light absorbing layer, and a second electrode. A step portion is formed on the substrate corresponding to the edge area.

## Description

### CROSS-REFERENCE TO RELATED APPLICATIONS

The present application claims priority under 35 U.S.C. 119 and 35 U.S.C. 365 to Korean Patent Application No. 10-2009-0059504 (June 30, 2009), which is hereby incorporated by reference in its entirety.

### BACKGROUND

The present disclosure relates to a solar battery and method for manufacturing the same.

As demands of energy increases, solar batteries for converting solar energy into electrical energy are being actively developed.

Particularly, copper-indium-gallium-selenide-based (CIGS-based) solar batteries having a substrate structure are being widely used. Here, the substrate includes a glass substrate, a metal back electrode layer, a p-type CIGS-based light absorbing layer, a high resistance buffer layer, and an n-type window layer.

Such a solar battery is manufactured by depositing several layers sequentially from a back surface of a substrate. Here, each layer may have areas with partially different deposition levels.

Accordingly, there may be a limitation that a solar battery module is connected to the external objects to cause short-circuit, thereby reducing electrical characteristics of the solar battery.

### SUMMARY

Embodiments provide a solar battery which has enhanced electrical characteristics through a simple process, and a method of manufacturing the same.

In one embodiment, a solar battery according to embodiments includes: a substrate having an effective area and an edge area disposed outside the effective area; and a solar battery cell formed on the effective area of the substrate and including g a first electrode, a light absorption layer, and a second electrode. A step portion is formed on the substrate to correspond to the edge area.

In another embodiment, a method for manufacturing a solar battery according to embodiments includes: forming a solar battery cell including a first electrode, a light absorption layer, and a second electrode on a substrate; and partially removing an edge area of the substrate to form a step portion.

In further another embodiment, a method of manufacturing a solar battery includes: preparing a substrate with a step portion on an edge area; forming a solar battery cell including a first electrode, a light absorption layer, and a second electrode in a front surface of the substrate; and removing the first electrode, the light absorption layer, and the second electrode to correspond to the edge area.

The details of one or more embodiments are set forth in the accompanying drawings and the description below. Other features will be apparent from the description and drawings, and from the claims.

### BRIEF DESCRIPTION OF THE DRAWINGS

Figs. 1 to 11 are views illustrating a method of manufacturing a solar battery according to an embodiment.

Figs. 12 to 14 are views illustrating a method of manufacturing a solar battery according to another embodiment.

### DETAILED DESCRIPTION OF THE EMBODIMENTS

In the description of embodiments, it will be understood that when a substrate, a layer, a film, or an electrode is referred to as being 'on' or 'under' another substrate, layer, film, or electrode, the terminology of 'on' and 'under' includes both the meanings of 'directly' and 'indirectly'. Further, the reference about 'on' and 'under' each component layer will be made on the basis of drawings. In addition, the sizes of elements and the relative sizes between elements may be exaggerated for further understanding of the present disclosure.

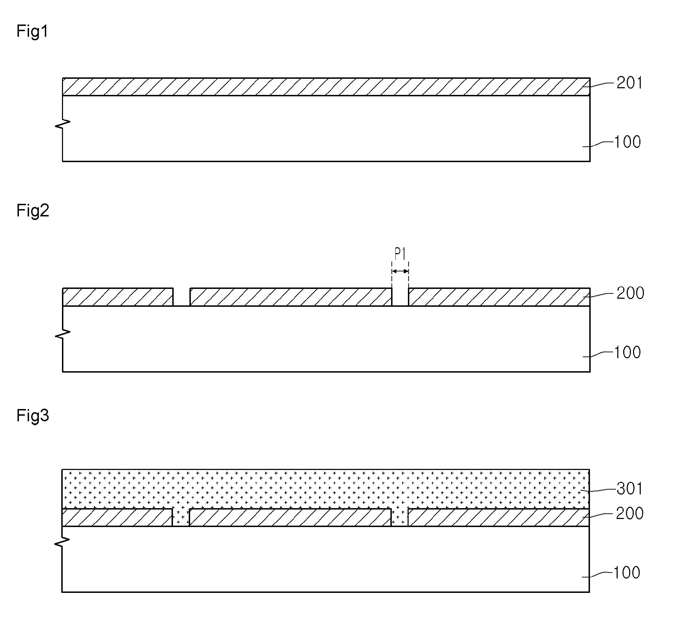

Referring to Fig. 1, the back electrode layer 201 is formed on a substrate 100.

The substrate 100 may be formed of glass, ceramic, metal, or polymer. For example, the glass substrate may be formed of sodalime glass or high strained point soda glass. The metal substrate may be a substrate including stainless steal or titanium. The polymer substrate may be formed of polyimide.

The substrate 100 may be transparent. The substrate 100 may be rigid or flexible.

The back electrode layer 210 is formed of a conductive material such as metal. For example, a sputtering process may be performed using molybdenum (Mo) as a target to form the back electrode layer 210. This is done because Mo has high electrical conductivity, an ohmic contact with a light absorption layer, and high temperature stability in Se atmosphere.

The Mo thin film that is the back electrode layer 210 should have a low specific resistance as an electrode and superior adhesion with the substrate 100 so that it prevents delamination from occurring due to a difference in thermal expansion coefficient.

For example, the back electrode layer 201 may have a thickness of about 900 nm to about 1,100 nm and have a sheet resistance of about 0.3 Ω/□.

The present disclosure is not limited to the material forming the back electrode layer 201. For example, the back electrode layer 201 may be formed of molybdenum (Mo) doped with sodium (Na) ions.

Although not shown, the back electrode layer 201 may be formed as at least one or more layers. When the back electrode layer 201 is formed as a plurality of layers, the layers of the back electrode layer 201 may be formed of different materials.

Referring to Fig. 2, a first through hole (P1) is formed in the back electrode layer 201. Then, the back electrode layer 201 is patterned to form a plurality of first electrodes (hereinafter, "back electrode") 200.

The first through hole P1 may selectively expose a top surface of the substrate 100.

For example, a patterning process may be performed using a mechanical or laser apparatus to form the first through hole P1. The first through hole P1 may have a width ranging from about 50 µm to about 70 µm.

The back electrode 200 may have a stripe or matrix shape by the first through hole P1 to correspond to each solar battery cell. The present disclosure is not limited to the above-described shape of the back electrode layer 200. For example, the back electrode layer 200 may have various shapes.

Referring to Fig. 3, a light absorption layer 301 is formed on the back electrode 200 and first through hole P1.

The light absorption layer 301 is formed of group Ib-IIIb-VIb compounds. In more detail, the light absorption layer 301 is formed of copper-indium-gallium-selenide (Cu(In, Ga)Se₂)-based (CIGS-based) compounds.

Alternatively, the light absorption layer 301 may be formed of copper-indium-selenide (CuInSe₂)-based (CIS-based) compounds or copper-gallium-selenide (CuGaSe₂)-based (CGS-based) compounds.

For example, to form the light absorption layer 301, a CIG-based metal precursor film is formed on the back electrode 200 using a copper target, an indium target, and a gallium target. Thereafter, the metal precursor film reacts with selenium (Se) through a selenization process to form a CIGS-based light absorption layer 301.

Also, a co-evaporation process using copper, indium, gallium, and selenide (Cu, In, Ga, and Se) may be performed to form the light absorbing layer 301.

For example, the light absorption layer 301 may have a thickness of about 1,500 nm to about 2,500 nm.

The light absorbing layer 301 receives external light to convert the light into electrical energy. The light absorbing layer 301 generates a photoelectromotive force through the photoelectric effects.

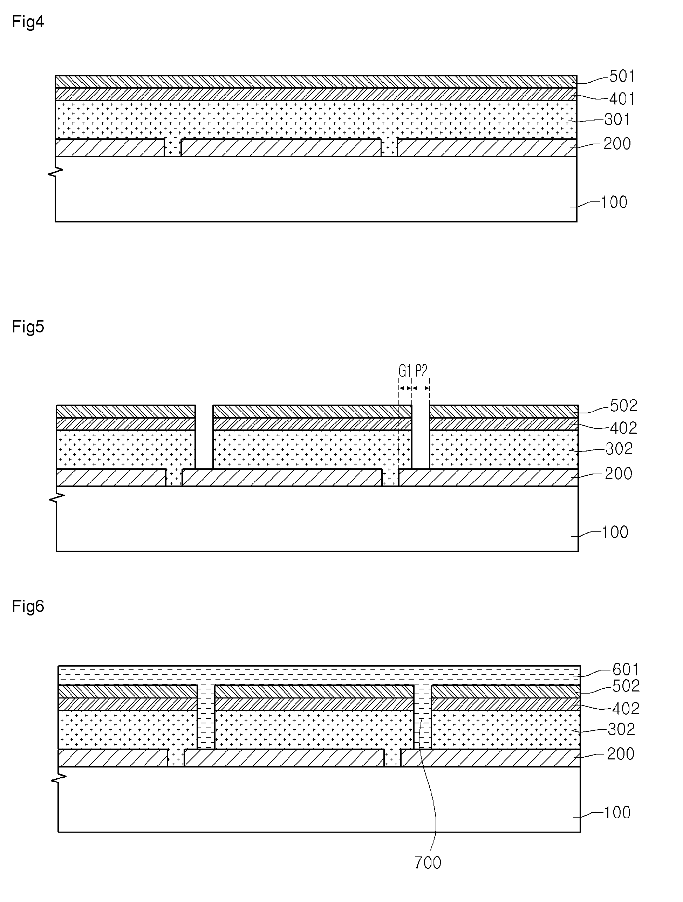

Referring to Fig. 4, the buffer layer 401 and the high resistance buffer layer 501 are formed on the light absorbing layer 301.

The buffer layer 401 may be formed as at least one or more layers on the light absorbing layer 301, and may be formed by depositing cadmium sulfide (CdS) through chemical bath deposition (CBD) process.

For example, the buffer layer 401 may have a thickness of about 40 nm to about 60 nm. Here, the buffer layer 401 is an n-type semiconductor layer, and the light absorbing layer 301 is a p-type semiconductor layer. Accordingly, the light absorbing layer 301 is pn-junctioned with the buffer layer 401.

The high resistance buffer layer 501 may be formed on the buffer layer 401 as a transparent electrode. For example, the high resistance buffer layer 501 may be formed of one of ITO, ZnO, and i-ZnO. A sputtering process may be performed using ZnO as a target material to form a ZnO layer, thereby forming the high resistance buffer layer 501).

For example, the high resistance buffer layer 501 may have a thickness of about 40 nm to about 60 nm.

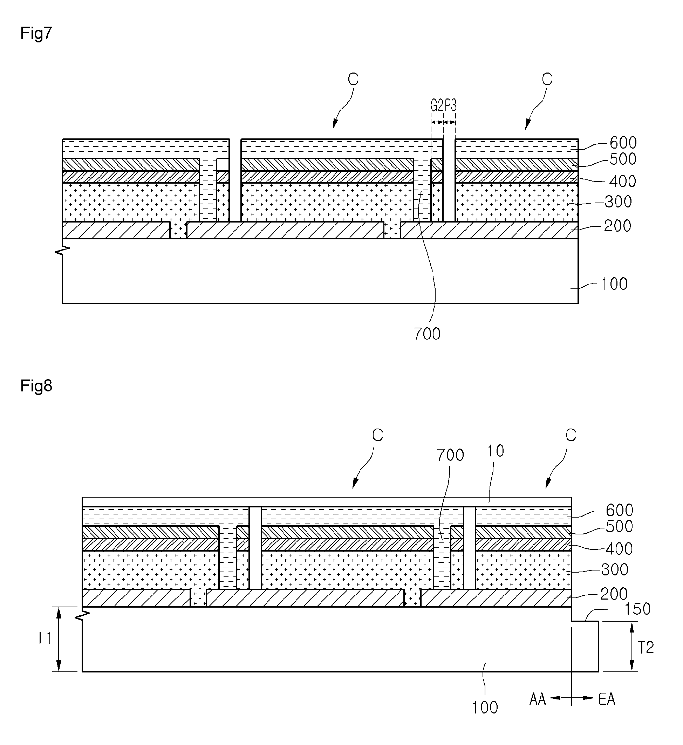

The buffer layer 401 and high resistance buffer layer 501 are disposed between the light absorbing layer 301 and the second electrode 600 (hereinafter, "front electrode") (see reference numeral 600 of Fig. 7, ditto) which will be formed later.

That is, since the light absorbing layer 301 and the front electrode 600 have great differences in the lattice constant and energy band gap, the buffer layer 401 and high resistance buffer layer 501 with a median between band gaps of the two materials are inserted to form a good junction.

In the present embodiment, two buffer layers may be formed on the light absorbing layer 301, but this is not limited thereto, and the buffer layer 401 may be formed in a single layer. Although two buffer layers are formed on the light absorbing layer 301 in the current embodiment, the present disclosure is not limited thereto. For example, the buffer layer may be formed as only a single layer.)

Referring to Fig. 5, a second through hole P2 passing through the high resistance buffer layer (see reference numeral 501 of Fig. 4), the buffer layer (see reference numeral 401 of Fig. 4), and the light absorbing layer (see reference numeral 301 of Fig. 4) is formed. Thus, the back electrode 200 may be selectively exposed by the second through hole P2 which is formed in the high resistance buffer layer 502, the buffer layer 402, and the light absorbing layer 302.

The second through hole P2 may be formed using a mechanical apparatus such as a tip or laser apparatus.

The second through hole P2 may be formed close to the first through hole P1.

For example, the second through hole P2 may have a width of about 60 µm to 100 µm, and a gap G1 between the first through hole P1 and second through hole P2 may be about 60 µm to 100 µm.

Referring to Fig. 6, a transparent conductive material may be stacked on the high resistance buffer layer 502 to form the front electrode layer 601.

When the front electrode layer 601 is formed, the transparent conductive material may be inserted into the second through hole P2 to form a connection wiring 700.

For example, the front electrode layer 601 may have a thickness of about 700 nm to about 900nm. And also, the front electrode layer 601 may have a sheet resistance of about 0.3 Ω/□ and a transmittance of about 80% to about 95%.

Since the front electrode layer 601 is a window layer which is pn-junctioned with the light absorbing layer 301 and functions as a transparent electrode in the front surface of a solar battery, the front electrode layer 601 is formed of zinc oxide (ZnO) having a high light transmittance and good electrical conductivity. The front electrode layer 601 may be formed of zinc oxide (ZnO) doped with aluminium or alumina (Al₂O₃), and thus have a low resistance value.

The front electrode layer 601 may be formed through deposition using a ZnO target in RF sputtering, reactive sputtering using a Zn target, and metal organic chemical vapor deposition.

And also, the front electrode layer 601 may be formed in a dual structure in which an indium thin oxide (ITO) thin film with great electro-optical characteristics is deposited on a zinc oxide thin film.

Referring to Fig. 7, a third through hole P3 passing through the front electrode layer (see reference numeral 601 of Fig. 6), the high resistance buffer layer (see reference numeral 502 of Fig. 6), the buffer layer (see reference numeral 402 of Fig. 6), and the light absorbing layer (see reference numeral 302 of Fig. 6) is formed.

The third through hole P3 may selectively expose the back electrode 200. The third through hole P3 may be formed close to the second through hole P2.

For example, the third through hole P3 may have a width of about 60 µm to 100 µm, and the gap G2 between the third through hole P3 and second through hole P2 may be about 60 µm to 100 µm.

The third through hole P3 may be formed by laser irradiation or a mechanical method such as tipping.

Accordingly, the light absorbing pattern 300, the buffer pattern 400, the high resistance buffer pattern 500, and the front electrode 600 which are separated from each other by the third through hole (P3) are formed. That is, solar battery cells C may be separated by the third through hole P3.

The light absorbing pattern 300, the buffer pattern 400, and the front electrode 600 may be disposed in a stripe or matrix shape by the third through hole (P3).

The present disclosure is not limited to the foregoing shape of the third through hole 3. For example, the third through hole 3 may have various shapes.

In this case, solar battery cells C may be connected to each other by the connection wiring 700. That is, the connection wiring 700 may physically and electrically connect the back electrode 200 of one solar battery cell C to the front electrode 600 of the other solar battery cell C which is close to the solar battery cell C. Thus, a plurality of solar battery cells C are connected to each other in series.

Referring to Fig. 8, a portion of the substrate 100 corresponding to an edge area EA is removed while removing a portion corresponding to the edge area EA of the solar battery cell C to form a step portion 150. Thus, the effective area AA of the substrate 100 in which a solar battery cell C is formed may have a first thickness T1. The edge area EA in which the step portion 150 is formed may have a second thickness T2 about 10 to 50 % less than the first thickness T1. For example, the second thickness T2 may range from about 0.9 mm to about 1.1 mm.

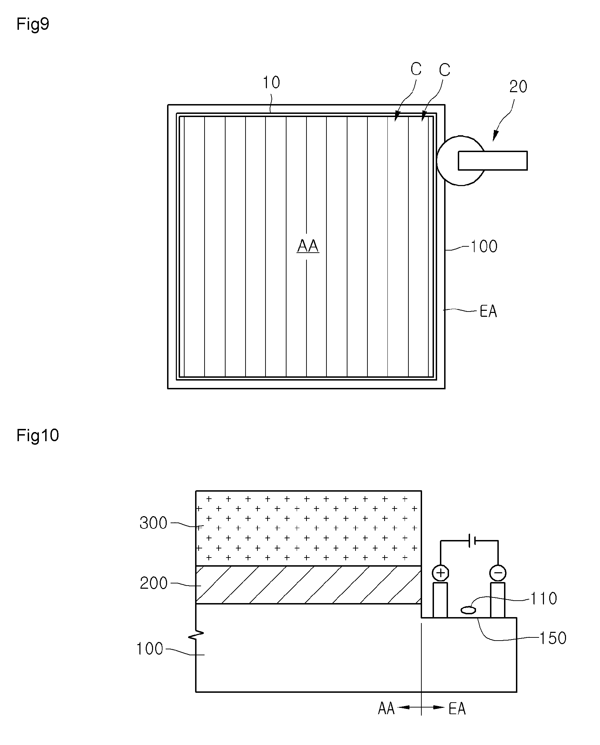

As an example, the edge area EA may be formed outside the effective area AA, and may be formed along the four edges of the substrate 100 as shown in FIG. 9.

In the present embodiment, the area corresponding to the edge area EA in which each layer may be deposited unconformally is removed, thereby enhancing electrical characteristics of the solar battery.

In removing the edge area EA in the solar battery cell C, a portion of the substrate 100 is removed to form the step portion 150. Thus, in removing a portion of area, an unnecessary short circuit can be prevented.

In more details, when removing only the area corresponding to the edge area EA of the solar battery cell C with the step portion 150 not being formed, the back electrode 200 remains partially, or particles of the light absorbing pattern 300 and buffer pattern 400 may remain apart from the substrate 100. Thus, there is a problem in which an unnecessary short circuit may occur.

In the present embodiment, however, a portion of the substrate 100 is removed together with a portion of the solar battery cell C to form the step portion 150 on the substrate 100. Thus, the back electrode 200 cannot remain in the edge area EA. And also, even when particles of light absorbing pattern 300 and buffer pattern 400 are detached, the step of the step portion 150 can prevent the unnecessary short circuit.

This process of removing the edge area EA may be performed by a mechanical apparatus such as polisher and grinder. A detailed method of removing a cell C1 of the edge area EA to form the step portion 150 on the substrate 100 will be described with reference to Figs. 8 through 10.

First, a protective film 10 is formed corresponding to the effective area AA, as illustrated in Figs. 8 and 9. Thus, the protective film 10 may selectively expose the area corresponding to the edge area EA. For example, the protective film 10 may be formed of a material such as Teflon, PVC, and PVP.

The area corresponding to the edge area of the substrate 100 may be removed by a mechanical apparatus 20, using the protective film 10 as a mask. That is, a mechanical friction process can be performed on the substrate 100 and solar battery cell C by a polisher or grinder to process the edge area EA.

Accordingly, each layer of the solar battery cell C which includes the back electrode 200 corresponding to the edge area EA may be removed. The substrate 100 may be removed by a predetermined thickness to form the step portion 150. The step portion 150 may have a height lower than the substrate 100, thereby improving the electrical short circuit characteristic in the solar battery area EA.

As illustrated in FIG. 10, a metal particle 110 which is generated in forming the step portion 150 may remain in the surface of the step portion 150. The particle 110 may be removed by applying high voltage to the step portion 150 with a high voltage apparatus.

Accordingly, the particle which may remain in the step portion 150 is additionally removed, thereby preventing short circuit and ensuring insulation in the edge part of the solar battery.

The step portion 150 is formed by the mechanical process in the present embodiment, thereby preventing generation and re-absorbing of particles which may occur in thermal removal using laser and preventing dielectric breakdown due to the particle.

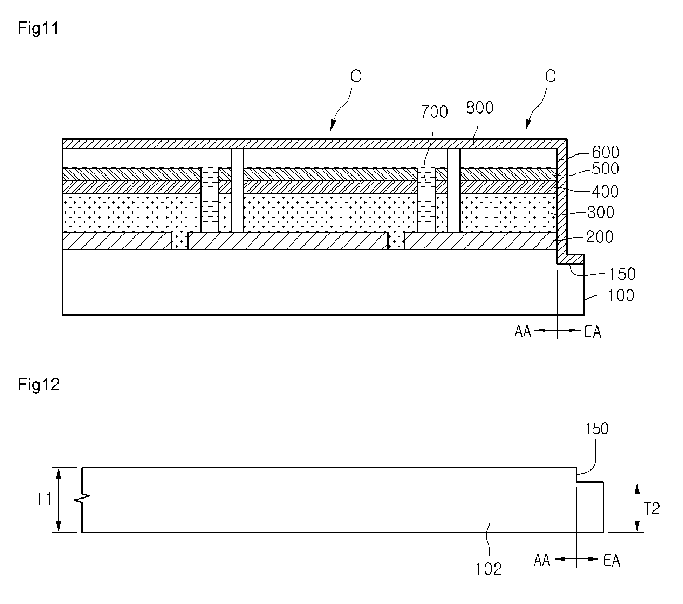

Hereinafter, referring to FIG. 11, an eva film 800 may be adhered onto the substrate 100 including the solar battery cells C in the lamination process.

At this point, the step portion 150 in the substrate 100 may widen an area on which the eva film 800 is adhered. Accordingly, the adhesive strength between the eva film 800, and the solar battery cell C and substrate 100 can be enhanced.

Hereinafter, a method of manufacturing a solar battery according to the second embodiment will be described with reference to FIGS. 12 to 14. Detailed descriptions of the second embodiment which are the same as or similar to the first embodiment are omitted, and differences are described in detail.

As shown in FIG. 12, a substrate 102 having the step portion 150 formed in the edge area is prepared in the present embodiment. The effective area AA of the substrate 100 in which a solar battery cell C is formed may have a first thickness T1. The edge area EA in which the step portion 150 is formed may have a second thickness T2 about 10 % to about 50 % less than the first thickness T1. For example, the second thickness T2 may range from about 0.9 mm to about 1.1 mm.

The present embodiment differs from the second embodiment forming the step portion 150 after forming the solar battery cell C, in that the step portion 150 is formed in the substrate 012 before forming the solar battery cell C.

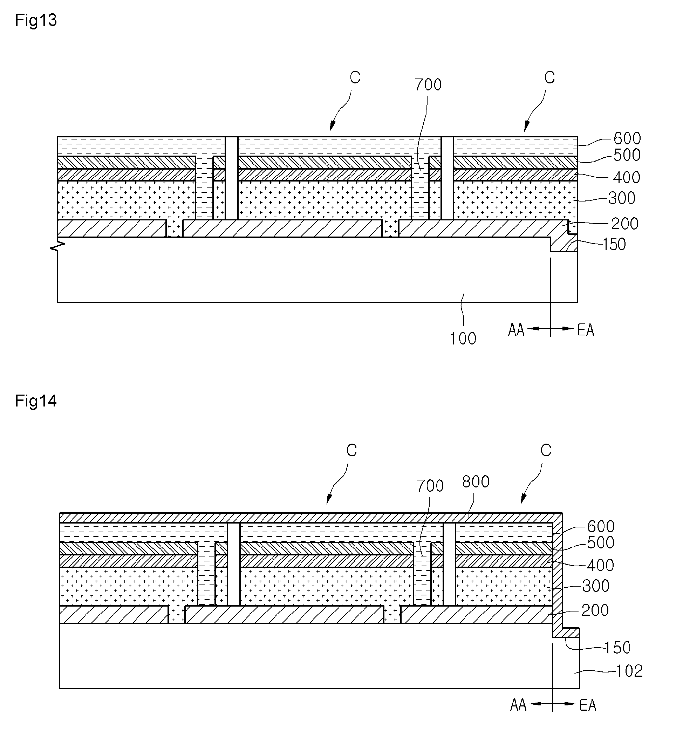

Next, as shown in FIG. 13, the solar battery cells C are formed in the substrate 102. Since the solar battery cells C are formed over the entire surface of the substrate 102, the solar battery cells C are formed only on the step portion 150.

The process of forming solar battery cells C is extremely similar to that illustrated in FIGS. 1 to 7, and thus detailed description is omitted.

As illustrated in FIG. 14, the solar battery cells C is removed in a portion where the step portion 150, a portion corresponding to the edge area EA, is formed. And also, the eva film 800 is formed to cover the step portion 150 and solar battery cells C.

In removing the solar battery cells C in a portion with the step portion 150 formed therein, as shown in FIG. 9, the protective film 10 may be formed on the effective area AA. And also, the back electrode 200, the light absorbing pattern 300, and the front electrode 600 may be removed in a portion with no protective film formed thereon. However, the embodiment is not limited thereto, but the protective film 10 may not be formed.

Laser scribing or sand blasting may be used in removing a portion of the solar battery cell C.

Since the step portion 150 is formed on the substrate 102 in advance, even when a particle is generated using laser, the step of the step portion 150 can prevent short circuit caused by the particle. Accordingly, the laser apparatus which was used in forming a through hole may be used in removing a solar battery cell C. Separate polisher or grinder is unnecessary to form the step portion 150, thereby reducing facility cost.

According to embodiments, the step portion is formed on the edge area of the substrate supporting solar battery cells, thereby ensuring insulation and enhancing the electrical characteristic in the edge area.

In this case, the step portion may be formed in a simple mechanical process. In addition, a particle which is generated additionally in forming the step portion can be removed by applying high voltage. In particular, generation of particles can be minimized in a thermal process such as a common laser process, thus minimizing dielectric breakdown. Furthermore, the adhesive strength of the eva film can be enhanced by an irregular surface due to the step portion.

In the case of the substrate with the step portion, the existing laser apparatus can be used, thus preventing a short circuit which is caused by a particle due to a thermal process.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar battery comprising:
a substrate having an effective area and an edge area disposed outside the effective area; and
a solar battery cell formed on the effective area of the substrate, the solar battery comprising a first electrode, light absorbing layer, and second electrode,
wherein a step portion is formed on the substrate to correspond to the edge area.

2. The solar battery of claim 1, wherein, in the substrate, the effective area has a first thickness and the edge area with the step portion has a second thickness less by about 10% to about 50% than the first thickness.

3. The solar battery of claim 1, further comprising an eva film formed to cover the solar battery cell and the step portion.

4. The solar battery of claim 1, wherein the solar battery cell comprises a plurality of serially connected solar battery cells.

5. A method for manufacturing a solar battery comprising:
forming a solar battery cell comprising a first electrode, a light absorbing layer, and a second electrode on a substrate; and
partially removing an edge area of the substrate to form a step portion.

6. The method of claim 5, wherein, in the forming of the step portion, the edge area of the solar battery cell is removed at the same time.

7. The method of claim 5, wherein, in the forming of the step portion, a grinder or polisher is used.

8. The method of claim 5, wherein the forming of the step portion comprises:
forming a protective film corresponding to the effective area except for the edge area; and
partially removing the substrate corresponding to the edge area without forming the protective film.

9. The method of claim 5, wherein the edge area with the step portion has a thickness less by about 10% to about 50% than the effective area without forming the step portion.

10. The method of claim 5, further comprising forming an eva film, the eva film covering the solar battery cell and the step portion.

11. The method of claim 5, wherein the forming of the solar battery cell comprises:
forming the first electrode, the light absorbing layer, and the second electrode; and
forming a separation pattern which passes through the first electrode and the light absorbing layer to form a plurality of solar battery cells connected to each other in series.

12. A method for manufacturing a solar battery comprising:
preparing a substrate with a step portion on an edge area;
forming a solar battery cell comprising a first electrode, a light absorbing layer, and a second electrode in a front surface of the substrate; and
removing the first electrode, the light absorbing layer, and the second electrode to correspond to the edge area.

13. The method of claim 12, wherein, in the removing of the first electrode, the light absorbing layer, and the second electrode, a laser scribing or sand blasting process is performed.

14. The method of claim 12, wherein the removing of the first electrode, the light absorbing layer, and the second electrode comprises:
forming a protective film corresponding to the effective area except for the edge area; and
removing the first electrode, the light absorbing layer, and the second electrode on the edge area without forming the protective film.

15. The method of claim 12, wherein the edge area with the step portion has a thickness less by about 10% to about 50% than the effective area without the step portion formed therein.

16. The method of claim 12, further comprising forming an eva film, the eva film covering the solar battery cell and the step portion.

17. The method of claim 12, wherein the forming of the solar battery cell comprises:
forming the first electrode, the light absorbing layer, and the second electrode; and
forming a separation pattern which passes through the first electrode and the light absorbing layer to form a plurality of solar battery cells connected to each other in series.
